# EUROPEAN PATENT SPECIFICATION

(11) **EP 2 789 021 B1**
(45) Date of publication and mention of the grant of the patent: **11.07.2018**
(21) Application number: 12858697.1
(22) Date of filing: 05.12.2012
(51) Int. Cl.: H01L 31/054

(54) **HIGH CONCENTRATION PHOTOVOLTAIC MODULES AND METHODS OF FABRICATING THE SAME**
HOCHKONZENTRIERTE PV-MODULE UND VERFAHREN ZU IHRER HERSTELLUNG
MODULES PHOTOVOLTAÏQUES À HAUTE CONCENTRATION ET LEURS PROCÉDÉS DE FABRICATION

(30) Priority: 09.12.2011 US 201161568900 P
(43) Date of publication of application: 15.10.2014
(73) Proprietor: X-Celeprint Limited, Cork (IE)
(72) Inventor: SEEL, Steven, Cary, North Carolina 27519 (US); MENARD, Etienne, Durham, North Carolina 27713 (US); KNEEBURG, David, Durham, North Carolina 27707 (US); KENDRICK, Baron, Cary, North Carolina 27518 (US); FURMAN, Bruce, Plattsburgh, New York 12901 (US); WAGNER, Wolfgang, Chapel Hill, North Carolina 27514 (US); JASINSKI, Ray, Chapel Hill, North Carolina 27517 (US); BURROUGHS, Scott, Raleigh, North Carolina 27617 (US)
(74) Representative: Cockerton, Bruce Roger
(86) International application number: PCT/US2012/067920
(87) International publication number: WO 2013/130152

(56) References cited:
- EP-A2- 1 956 662
- WO-A1-91/18419
- WO-A1-2008/143635
- WO-A1-2009/061493
- WO-A2-2010/091391
- US-A1- 2008 185 034

## Description

### Field Of The Invention

The invention is in the field of photovoltaics. More specifically the invention is in the field of high concentration photovoltaic module design and fabrication.

### Background Of The Invention

With the increasing demand for "green" solar power solutions in the global marketplace, cost reduction, manufacturing optimization, end-product reliability, high solar concentration, and performance efficiency have become targets of new solar module array designs and their fabrication. Related targets for high concentration photovoltaic modules may include lower cost backplanes and/or lower overall cost. Other solutions may also be used to achieve low cost secondary high index optics, which can be important for achieving very high concentration of sunlight onto micro-cell photovoltaic solar cells. Further goals include designs and methods for combining and interconnecting the solar array modules and affixing the solar module arrays and their enclosures onto solar tracking systems.

Flexible backplanes, lamination and unibody enclosures are described, for example, in U.S. Patent No. 7,638,708 titled "Laminated Solar Concentrating Photovoltaic Device," U.S. Patent 6,399,874 titled "Solar Energy Module And Fresnel Lens For Use In Same," U.S. Patent Application Publication No. 2009/0223555 titled "High Efficiency Concentrating Photovoltaic Module Method and Apparatus" and U.S. Patent Application Publication No. 2010/0282288 titled "Solar Cell Interconnection On A Flexible Substrate." Silicone encapsulation for concentrator photovoltaics is described, for example, in U.S. Patent Application Publication No. 2010/0313954 titled "Concentrated Photovoltaic System Receiver for III-V Semiconductor Solar Cells," U.S. Patent Application Publication No. 2011/0048535 titled "Encapsulated Concentrated Photovoltaic System Subassembly for III-V Semiconductor Solar Cells," U.S. Patent Application Publication No. 2010/0065120 titled "Encapsulant With Modified Refractive Index", and U.S. Patent Application Publication No. 2010/0319773 titled "Optics For Concentrated Photovoltaic Cell." Spherical glass secondary concentrator photovoltaics are described, for example, in U.S. Patent Application Publication No. 2010/0236603 titled "Concentrator-Type Photovoltaic (CPV) Modules, Receiver and Sub-Receivers and Methods of Forming Same." Photovoltaic module bonding to rails for optical and thermal performance is described, for example, in U.S. Patent No. 7,868,244 titled "Solar CPV Cell Module And Method Of Safely Assembling, Installing, And/Or Maintaining The Same," and in U.S. Patent Application Publication No. 2009/0261802 titled "Simulator System And Method For Measuring Acceptance Angle Characteristics Of A Solar Concentrator." US2008/185034 and WO2010/091391 each discloses an arrangement relevant to the present invention.

### Summary Of The Invention

The invention is defined in the independent claims. Solutions for realizing high efficiency solar modules may employ enclosures with low cost backplanes and low cost secondary high index optics to provide very high concentration of sunlight onto micro-cell photovoltaic solar cells, as well as designs and methods for combining and interconnecting solar array module elements and affixing solar arrays and their enclosures onto solar tracking systems. The use of micro-cells allows for the deployment of a large number of photovoltaic cells within each module, which may increase the overall efficiency and reliability of the photovoltaic modules.

In summary, some embodiments of the invention provide a high concentration photovoltaic (HCPV) module that includes a backplane comprising a patterned circuit on a dielectric substrate. The backplane provides electrical interconnection of a hybrid circuit including a plurality or multitude of solar cell receivers in a parallel-series wiring configuration in the enclosure, with a single reverse bias protection diode protecting each parallel bock comprising multiple solar cells, thus saving costs. The patterned circuit could be an etched layout of electrodeposited or rolled annealed copper with an anti-tarnish coating; a screen- or stencil-printed conductive ink made from graphite, copper, silver; a laminated, glued, or otherwise adhesive-bonded metal tape layup; or a slitted copper sheet provided by a roll-to-roll lamination approach. The dielectric substrate can be FR4, epoxy-impregnated glass fiber mat, polyimide, polyester, and/or some other printed circuit board dielectric material. The substrate can be thick enough to be free-standing without edge supports (0.063" thickness typical), or as thin as 0.001" as in a flexible circuit. The very thin substrates can reduce material utilization and decrease the thermal resistance. The substrates can be produced using low-cost high-volume roll-to-roll circuit fabrication methods. The solar cell(s) and diode(s) could be electrically connected to the patterned circuit though a solder reflow process, laser melting of eutectic solder, or using a metal-filled epoxy.

The invention includes a module housing or enclosure, such as a unibody enclosure. The unibody enclosure provides a closed-bottom rigid frame, to which the backplane including the interconnected array of supported multijunction solar cells, a primary optical element, a junction box, and rails for mounting the module onto the tracker frame are attached. The unibody module enclosure may have the form of a deep tray that can be fabricated using a deep-draw metal stamping process, seam welding of a roll-formed or break-formed metal enclosure, or metal casting in a monolithic mold. All the aforementioned fabrication methods can create an enclosure with closed-bottom geometry. The module enclosure can also be fabricated from plastic or composite material using a sheet-molding compound, thermoset, or thermoplastic injection molding. As a variant, the enclosure can be composite, with overmolded plastic sidewalls over a metal bottom insert.

The backplane is laminated into the module housing or enclosure. For example, the backplane lamination may be performed after surface mount technology (SMT) attachment of solar cells and diodes to the backplane, such that the lamination is performed with a circuit that is populated with components. For lamination of the backplane into the module enclosure an adhesive is used, such as a single or dual-component epoxy, polyurethane, acrylic, and/or silicone-based adhesive. Depending on the choice, the adhesive can be cured at room temperature, and/or with a heat source or the addition of humidity or UV to promote curing. Additionally or alternatively, the adhesive can be a pressure sensitive adhesive or acrylic or silicone in tape form or sprayed as a hot melt. The lamination of the backplane can be accomplished using vacuum lamination in a diaphragm or platen press, using a hot-roll lamination press, and/or using an appropriate pressure distribution to improve contact to the adhesive and to reduce or minimize trapped air pockets. A series of small vent holes can also be added to the backplane to reduce the likelihood of trapping large voids at the adhesive interface. Alignment of the backplane to the module enclosure can be accomplished using mechanical references such as alignment pins or stamped/molded features in the module enclosure. Additionally or alternatively, alignment can be accomplished using optical pattern recognition through locating fiducials on the backplane and enclosure.

The invention further includes a secondary lens element, such as a spherical glass bead attached with silicone. In particular, the silicone is an encapsulant layer used to attach and overcoat the spherical glass secondary lens element to the individual solar cells. The silicone overcoating can be carried out prior to attaching a primary lens element to the module. Also, an optically clear silicone layer can be positioned between the solar cell and the spherical glass secondary lens element to provide mechanical attachment of the secondary lens element, reduce reflection losses by improving index matching, and/or improve reliability by encapsulating the III-V solar cell. The silicone can be dispensed using needle dispense, spray coating, swirl coating, flood filling, curtain coating, gap coating, metering rod coating, slot die coating, dip coating, and/or air-knife coating. The silicone can be an addition-cure or neutral-cure system, which includes metal-catalyzed cure, moisture cure, peroxide cure, oxime-based, acid cure, or UV cure systems. The process for the attachment can include a bead drop with silicone attach, whereby the bead drop can be performed by placing the spherical glass secondary lens element above the solar cell prior to the silicone curing. The bead drop can be accomplished using end-of-arm tooling to accurately place one bead at a time onto an individual solar cell. Alternately, the bead drop can be realized in a massively parallel fashion using a trap-door stencil to drop an array of beads onto a multitude of solar cells in a single operation. The silicone overcoating after the bead drop may use similar dispense techniques and/or silicone materials as used for the underfill. The overcoat can act as a thick-film antireflection coating, and may allow for the use of a secondary lens element with a lower surface quality by smoothing out surface roughness, defects, and/or other imperfections in the secondary lens surface.

Some embodiments of the invention further include a junction box with a through-board connector that provides a path for the wiring from the backplane contacts to a set of solar connectors. The backplane includes a through-board connector that can be a bottom-entry connector, header pin receptacle, test-pin socket, or some other structure with which electrical connection can be made to the backplane. Additionally or alternatively, the backplane can have backside pads that are electrically contacted via direct soldering or ultrasonic bonding to junction box leads. The solar wiring and connectors may include components rated for photovoltaic use.

The invention further includes a primary lens element comprising refractive optics fabricated as planoconvex spherical or aspherical lenses, Fresnel lenses or multi-faceted lenses using materials such as acrylic (PMMA), silicone (PDMS), glass and co-molded products. In some embodiments, the primary lens element can be of either poly(methyl methacrylate) (abbreviated as PMMA), silicone on glass (plano-convex, Fresnel or faceted). As part of the massively parallel processing approach of embodiments of the invention, the primary lenses can be molded into a single array, such that only one alignment may be made to the multitude (hundreds) of receivers rather than a multitude of alignments (e.g., one alignment for each receiver). The primary lens can be attached to the unibody with a single continuous seal.

Other methods and/or devices according to some embodiments will become apparent to one with skill in the art upon review of the following drawings and detailed description. It is intended that all such additional embodiments, in addition to any and all combinations of the above embodiments, be included within this description, be within the scope of the invention, and be protected by the accompanying claims.

### Brief Description of Figures

Figure 1 is a partial cut view drawing of a HCPV module assembly depicting some embodiments of the present invention.
Figures 2a-2b illustrate methods for surface mounting CPV sub-receivers onto a flexible backplane according to some embodiments of the present invention.
Figure 3 illustrates methods for laminating into a HCPV module enclosure a flexible backplane populated with an array of sub-receivers, according to some embodiments of the present invention.
Figures 4a-4b illustrate methods for attaching a spherical glass secondary lens onto a CPV sub-receiver.
Figures 5a-5b illustrate methods for over-coating and encapsulating a HCPV receiver assembly with an optically clear silicone layer according to the present invention.
Figure 6 illustrates methods for attaching a primary lens array onto a unibody HCPV module enclosure with a single continuous seal according to some embodiments of the present invention.
Figure 7 illustrates methods for attaching an array of HCPV modules to metal rails and junction boxes fitted with electrical harnesses, according to some embodiments of the present invention.
Figures 8a-8b illustrate methods for establishing electrical contacts to a backplane laminated inside a HCPV enclosure, and methods for sealing these electrical contacts in a potted junction box, according to embodiments of the present invention.

### Detailed Description

Embodiments of the present invention provide solar array module enclosures that allow for the adhering of a flexible backplane (including an array of micro-solar cells thereon) into the bottom surface of a unibody enclosure, so as to employ lower cost material for a flexible backplane, realize high throughput, low-temperature, low-cost lamination, and provide a unibody module enclosure design with lower cost, fewer parts and improved reliability.

Embodiments of the invention also provide a silicone overcoated, high-index glass bead secondary optic for practical solar concentration, and allow the use of a lower quality glass bead secondary optic by employing the silicone overcoat to fill rough spots and defects in the surface of the glass bead, thereby altering (e.g., reducing or increasing) the refractive index. The adhesion of the glass bead is also improved, thereby improving the reliability of solar cells by encapsulating them with silicone. The silicone overcoat also acts as a thick-film anti-reflection coating on the glass bead.

Embodiments of the invention also allow for rail bonding of multiple flattened modules into arrays, whereby multiple modules can be placed onto a reference surface that allows for flattening of the bottom of the enclosure to ensure correct backplane-to-lens distance and coplanarity of the lens and backplane. Rail bonding to the backside of the enclosure further improves thermal performance by improving conduction and increasing the stiffness of the array structure.

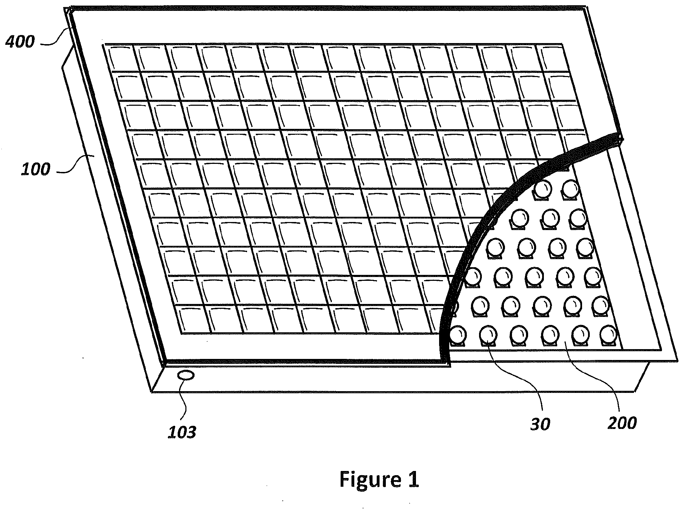

Some embodiments of the invention provide an HCPV module assembly as illustrated in Figure 1. The HCPV module assembly includes the following components: an array of solar cell receivers (30), which are surface-mounted onto a flexible backplane (200), which is laminated into a closed bottom unibody enclosure (100), which is sealed with a primary lens array (400) and a liquid water proof breather membrane (103).

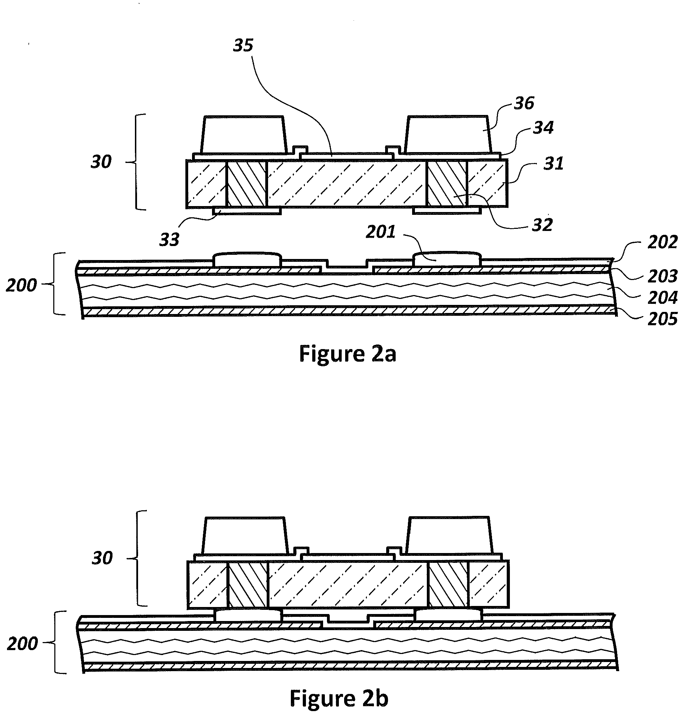

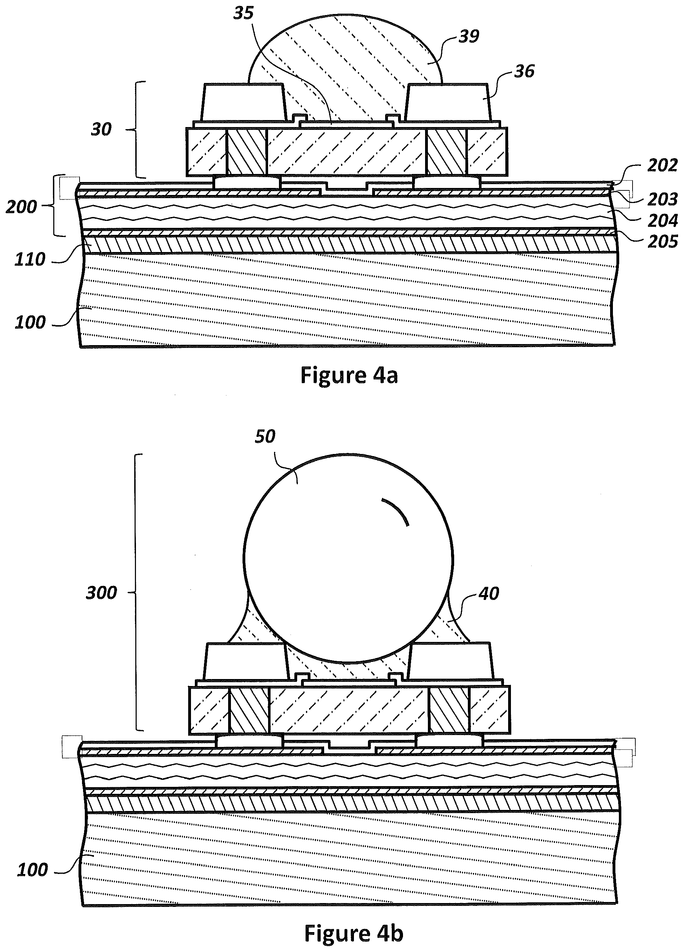

Figures 2a-2b illustrate a method for surface mounting CPV sub-receivers (30; generally referred to herein as a solar cell) onto a flexible backplane (200) according to some embodiments of the present invention. The surface mountable CPV sub-receiver (30) includes the following elements: an ultra-thin micro solar cell (35; also referred to herein as a thin-film photovoltaic layer) which can be micro-transfer printed onto to the upward-facing surface of a thermally conductive and electrically insulating interposer substrate (31); electrically conductive film interconnects (34) deposited on the upward-facing surface of the interposer substrate (31) that establish electrical connections to the solar cell (35); electrically conductive structures such as through vias (32) that establish electrical connection between the electrically conductive film interconnects (34) and contact pads (33) located on the downward-facing surface of the substrate (31); a spacer structure (36) which provides for both self aligning and supporting a spherically shaped secondary lens element (50; shown in Figure 4b). In some embodiments of the invention, the flexible backplane (200) includes a printed wiring board, which may be composed of a fiber reinforced prepreg fiberglass composite dielectric layer (204) sandwiched between two copper clad laminates (203 & 205). The metal traces (203) defined on the upward-facing surface of the backplane (200) allow for interconnecting CPV sub-receivers in parallel and/or series strings. A dielectric layer (202) is deposited and patterned onto the upward-facing surface of the metal traces (203). Solder paste (201) may be deposited onto the dielectric layer openings using methods such as screen printing.

An array of CPV sub-receivers (30) and discrete bypass diodes are picked and placed onto the backplane (200). The assembled board is then heated in a reflow furnace to complete this surface mount assembly process as shown in Figure 2b. In order to achieve distributed heat management with no heat sink, micro-cell based HCPV modules may rely on the use of a large number of sub-receiver parts. The number of bypass diodes used to protect the micro solar cells can be effectively reduced if multiple sub-receivers are interconnected in parallel blocks. In this embodiment, a single appropriately sized bypass diode may be used to protect multiple solar cells interconnected in each parallel block.

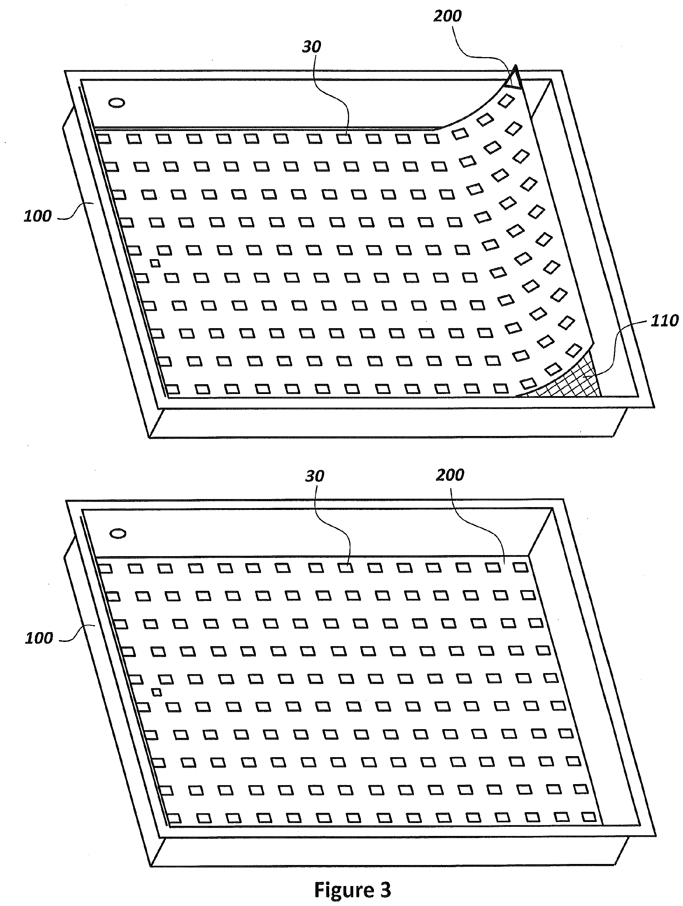

Figure 3 illustrates a method for laminating a flexible backplane (200) populated with an array of sub-receivers (30) into a HCPV module enclosure (100). An adhesive layer (110) is dispensed or laminated directly onto the backside of the flexible backplane (200) (e.g., on a surface opposite the array of sub-receivers (30)) and/or directly on a rigid internal surface of the HCPV module enclosure (100). The adhesive may be chosen from the following list of materials: dual-component epoxy, polyurethane, acrylic, and/or silicone based adhesives. The backplane (200) is then laminated to the internal surface of the HCPV module enclosure (100) by the adhesive layer. In some embodiments of the invention, the lamination of the backplane (200) is accomplished using a vacuum lamination technique in a diaphragm or platen press or with a hot-roll lamination press.

Figures 4a-4b illustrate methods for attaching a spherical glass secondary lens element (50) onto a CPV sub-receiver (30). In a first step, an optically clear silicone adhesive (39) is dispensed onto the upward facing surface of a sub-receiver (30) using liquid deposition methods such as needle dispense, spray coating, swirl coating, flood filling, curtain coating, gap coating, metering rod coating, slot die coating, dip coating, and/or air-knife coating. The spacer structure (36) defined on the upward facing surface of the sub-receiver provides for self aligning, centering, and supporting the spherically shaped secondary lens element. In some embodiments of the invention, a large array of spherical glass secondary lenses (50) may be dropped in a massively parallel manner using a trap-door stencil or a parallel plate fixture capable of holding and then dropping an array of spherical glass secondary lenses. The alignment accuracy of the bead drop tool may not be critical, as the final position of the spherical glass secondary lenses (50) can be ultimately defined by the position of spacer structures (36), insuring very accurate alignment of the spherical glass secondary lenses (50) to each micro solar cell (35). After completion of this bead drop process, the optically clear adhesive (39) may be partially or fully cured (40). This process step completes the formation of the full HCPV receiver assembly (300) which is then ready for an optional overcoat encapsulation process.

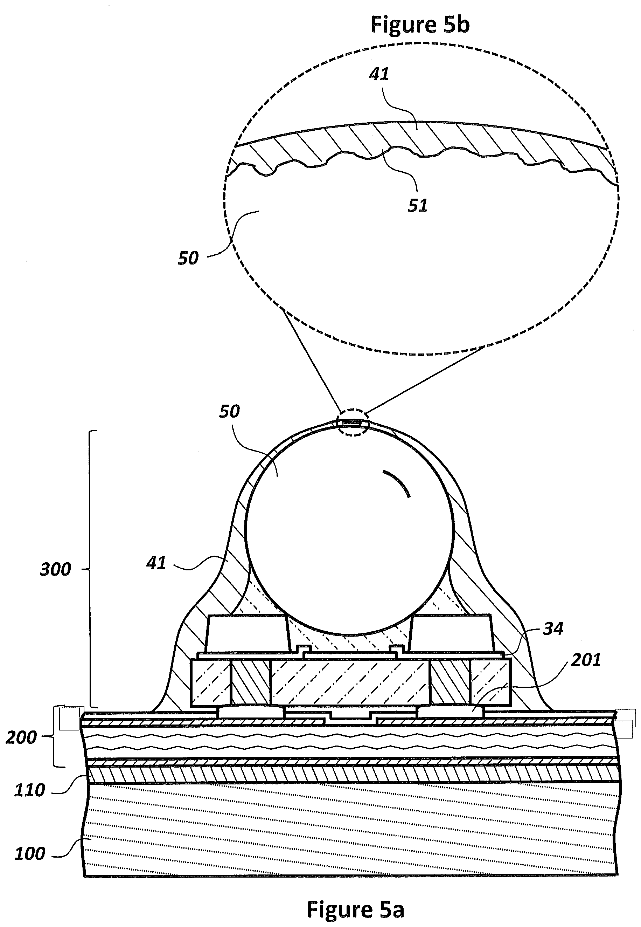

Figures 5a-5b illustrate methods for over-coating and encapsulating a HCPV receiver assembly (300) with an optically transparent encapsulant layer, such as a clear silicone layer (41). In particular, an optically clear silicone adhesive (41) is dispensed onto the top surface of a HCPV receiver assembly (300) using liquid deposition methods such as needle dispense, spray coating, swirl coating, flood filling, curtain coating, gap coating, metering rod coating, slot die coating, dip coating, and/or air-knife coating. As schematically illustrated in Figure 5b, the thin silicone layer (41) provides for filling and/or smoothing surface defects or asperities (51) which may be present on the surface of the spherical glass secondary lenses (51). The thin silicone layer (41) also encapsulates the sub-receiver thin film interconnects (34) and solder joints (201).

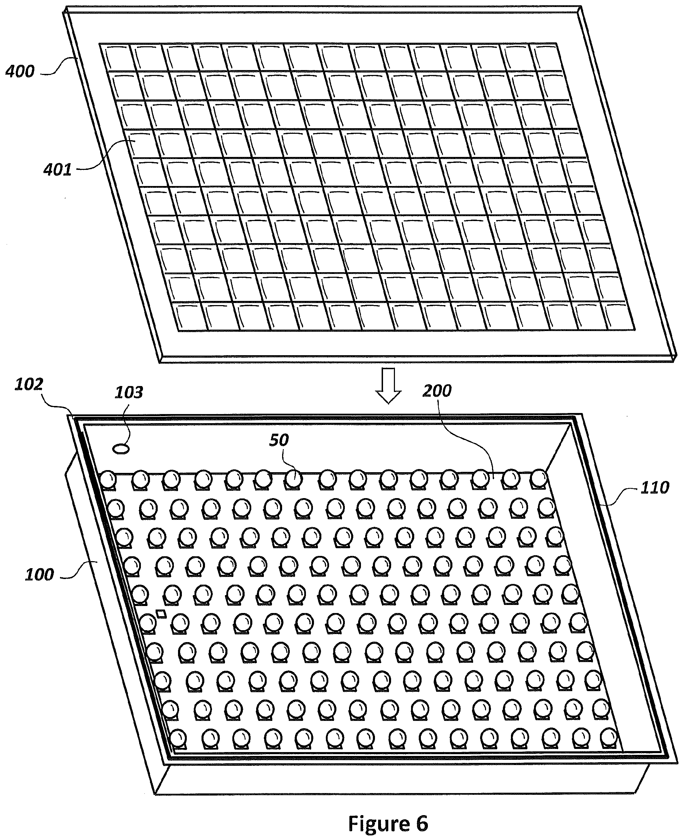

Figure 6 illustrates methods for attaching a primary lens element (400) including an array of lenslets (401) onto a unibody HCPV module enclosure (100) with a single continuous seal (110). In particular embodiments of the invention, an array of plano-convex, Fresnel or faceted lenslets (401) are molded onto the downward facing surface of a glass plate. These lenslets may be made out of Poly (methyl methacrylate) abbreviated as PMMA or silicone. In some embodiments of the invention, a continuous sealing layer or sealant (110) is first dispensed onto the upward facing perimeter surface of the enclosure flange (102), and/or the downward facing perimeter of the primary lens array. The primary lens element (400) is then aligned to the array of CPV receiver assemblies (300) and sealed to the HCPV enclosure (100). A breather membrane (103) is also attached to the enclosure, which completes the assembly of the HCPV module.

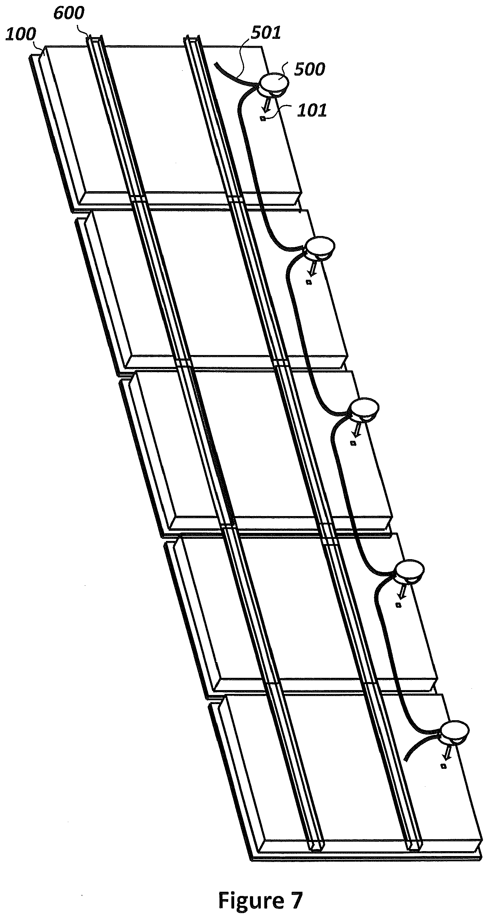

Figure 7 illustrates methods for attaching metal rails (600) and junction boxes (500) fitted with an electrical harness (501) to an array of HCPV modules (100). In some embodiments of the invention, the HCPV module enclosures (100) are temporally pulled flat against a reference surface in order to insure co-planarity between the different modules. Metal rails (600) are then bonded to the co-planar HCPV modules (100) using a structural adhesive. The adhesive bond line thickness can be accurately controlled. In further embodiments of the invention, mechanically fasteners such as metal studs can be used as an alternate or complementary method to attach the HCPV module enclosures (100). These mechanical fasteners can provide an electrical ground path between the HCPV module enclosure (100) and the metal rails (600). Mechanical fasteners can also provide for holding an array of HCPV module enclosures (100) in mechanical contact with a set of metal rails (600) while the structural adhesive is curing. In some embodiments of the invention, junction boxes (500) fitted with a pre-fabricated electrical harness (501) are attached to the HCPV modules (100). Electrical contacts are established to the backplane through openings (101) defined in the bottom surface of the HCPV module enclosure.

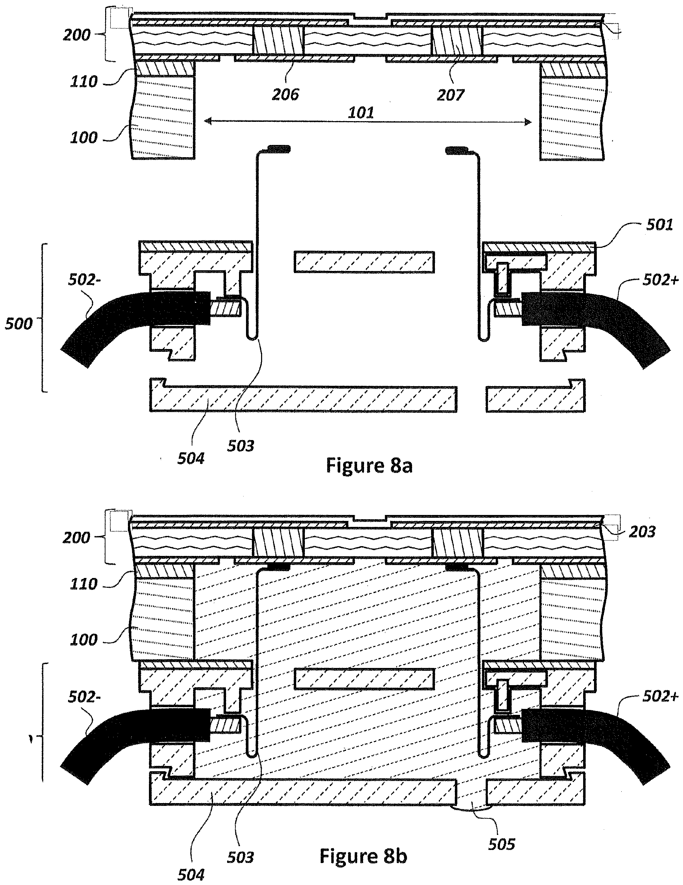

Figures 8a-8b illustrate exemplary methods of the invention for establishing electrical contacts from positive (502+) and negative (502-) external terminals or wires and contact pads (206) located on the bottom surface of a backplane (200) laminated inside a HCPV module enclosure (100). An opening (101) in the HCPV module enclosure (100) provides the clearance area to access the contact pads (206) from the bottom facing surface of the enclosure. In some embodiments of the invention, a junction box assembly (500) is attached to the bottom facing surface of the HCPV module enclosure (100) using an adhesive layer (501). Electrically conductive structures (503) such as metal pins or ribbons provide a mean for establishing electrical continuity between the positive (502+) and negative (502-) external wires and contact pads (206) located on the bottom surface of the backplane (200). In some embodiments of the invention, the electrically conductive structures (503) are welded to the contact pads (206) using a soldering robot. Through board vias (207) provides an electrical continuity path between the metal traces (203) defined on the upward-facing surface of the backplane (200) and the contact pads (206) located on the bottom surface of the backplane (200). In another embodiment of the invention, the positive (502+) and negative (502-) external wires may be soldered directly to the contact pads (206) located on the bottom surface of the backplane (200). In yet other embodiments of the invention, the backplane through board vias (207) may be replaced by a connector with through board pins thus providing another way for establishing electrical continuity between the metal traces (203) defined on the upward-facing surface of the backplane (200) and the contact pads (206) located on the bottom surface of the backplane (200). The junction box may be closed with a cap (504) and back-filled with potting compound (505).

The present invention has been described above with reference to the accompanying drawings, in which embodiments of the invention are shown. However, this invention should not be construed as limited to the embodiments set forth herein. Rather, these embodiments are provided so that this disclosure will be thorough and complete, and will fully convey the scope of the invention to those skilled in the art. In the drawings, the thickness of layers and regions are exaggerated for clarity. Like numbers refer to like elements throughout.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It will also be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

The terminology used in the description of the invention herein is for the purpose of describing particular embodiments only and is not intended to be limiting of the invention. As used in the description of the invention and the appended claims, the singular forms "a", "an " and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Thus, the regions illustrated in the figures are schematic in nature and their shapes are not intended to illustrate the actual shape of a region of a device and are not intended to limit the scope of the invention.

## Claims

1. A concentrator-type photovoltaic module, comprising:
a module enclosure (100) having a rigid bottom surface;
a flexible backplane (200) within the enclosure (100) and laminated to the rigid bottom surface by an adhesive layer (110), the flexible backplane (200) comprising an array of interposer substrates (31) including transfer-printed solar cells (35) thereon and an interconnect network (34) that provides electrical connections to the solar cells (35);
a respective secondary spherically shaped lens element (50) on respective ones of the solar cells (35) within the enclosure (100);
an optically transparent encapsulant layer (41) on a surface of the respective secondary lens element (50), wherein the encapsulant layer (41) overcoats the respective secondary lens element (50), wherein the encapsulant layer (41) is an optically clear silicone layer, and wherein the surface of the respective secondary lens element including the encapsulant layer thereon has a different refractive index than that of the secondary lens element; and
a primary lens element (400) attached to the enclosure (100) opposite to and spaced-apart from the rigid bottom surface, wherein the primary lens element (400) is positioned to concentrate light onto the respective ones of the solar cells (35) through the secondary lens element (50) thereon.

2. The module of Claim 1, comprising:
a transparent adhesive on a respective upward facing surface of the solar cells (35) and attaching the respective secondary lens element (50) thereon, wherein said transparent adhesive is an optically clear silicone layer.

3. The module of Claim 2, wherein the respective secondary lens element (50) includes one or more defects in the surface thereof, and wherein the encapsulant layer substantially fills the one or more defects to smooth the surface of the respective secondary lens element (50).

4. The module of Claim 3, wherein the solar cells (35) include a respective spacer structure (36) on the respective upward facing surface thereof, and wherein the secondary lens element (50) thereof is self-centered by the spacer structure (36).

5. The module of Claim 4, wherein the module enclosure (100) comprises a unibody frame having a closed-bottom geometry, wherein the rigid surface provides a bottom surface of the unibody frame, and wherein the flexible backplane (200) is laminated directly to the rigid surface by the adhesive layer (110).

6. The module of Claim 5, comprising:
a thermally conductive rail structure (600) attached to the rigid surface opposite the flexible backplane (200) and outside of the enclosure (100), wherein the rail structure (600) increases a flatness and/or stiffness of the rigid surface.

7. The module of Claim 6, comprising:
a junction box assembly (500) attached to the rigid surface opposite the flexible backplane (200) and outside of the enclosure (100), the junction box assembly (500) comprising electrically conductive structures (501) that extend through an opening (101) in the rigid surface to contact the interconnect network (34) of the flexible backplane (200) and provide electrical connections between the solar cells (35) and one or more external terminals.

8. The module of Claim 5 or any claim dependent on Claim 5, wherein the solar cells (35) respectively comprise a thermally conductive and electrically insulating interposer substrate (31) that is surface-mounted to the flexible backplane (200) and a thin film photovoltaic layer that is transfer-printed on the interposer substrate (31).

9. The module of Claim 8, wherein the primary lens element (400) comprises an array of lenslets attached to the unibody frame by a continuous seal extending along a perimeter of the unibody frame.

10. The module of Claim 9, wherein the flexible backplane (200) has a thickness of about 0.063 inches or less, wherein the one or more solar cells (35) have respective surface areas of less than 1 square millimeter, and wherein the lenslets of the primary lens element (400) respectively provide a lens-to-cell light concentration of about 1000 times or more.

11. The module of any preceding Claim, wherein the interconnect network (34) electrically connects the solar cells (35) in parallel blocks , wherein a respective reverse-bias protection diode on the flexible backplane (200) is connected in parallel with each parallel block of solar cells (35).

12. A method of fabricating a concentrator-type photovoltaic module, the method comprising:
laminating a flexible backplane (200) to an internal rigid surface of a module enclosure (100) using an adhesive layer (110), the flexible backplane (200) comprising an array of interposer substrates (31) including transfer-printed solar cells (35) thereon and an interconnect network (34) that provides electrical connections to the solar cells (35);
providing a respective spherically shaped secondary lens element (50) on respective ones of the solar cells (35) within the enclosure (100);
depositing an optically transparent encapsulation layer (40, 41) on the secondary lens element (50) of the respective ones of the solar cells (35), wherein a surface of the secondary lens element (50) including the encapsulation layer (40, 41) thereon has a different refractive index than that of the secondary lens element (50), and wherein said optically transparent encapsulation layer is an optically clear silicone layer; and
attaching a primary lens element (400) to the enclosure (100) opposite to and spaced-apart from the rigid surface, wherein the primary lens element (400) is positioned to concentrate light onto the respective ones of the solar cells (35) through the secondary lens element (50) thereon.

13. The method of Claim 12, wherein providing the secondary lens element (50) on the respective ones of the solar cells (35) comprises:
dispensing a transparent adhesive (40, 41) on the respective ones of the solar cells (35) opposite the backplane (200), wherein said transparent adhesive is an optically clear silicone layer; and
providing the spherically shaped secondary lens element (50) on the transparent adhesive (40, 41) on the respective ones of the solar cells (35), wherein the secondary lens (50) element includes one or more defects in the surface thereof,
and wherein depositing the optically transparent encapsulation layer (40, 41) comprises:
depositing the optically transparent encapsulation layer (40, 41) to substantially fill the one or more defects to smooth the surface of the secondary lens element (50) of the respective ones of the solar cells (35).

14. The method of Claim 13, wherein the solar cells (35) include a respective spacer structure (36) on a surface thereof, and wherein the secondary lens element (50) is self-centered by the spacer structure.

15. The method of Claim 14, wherein the module enclosure (100) comprises a unibody frame having a closed-bottom geometry, wherein the rigid surface defines a bottom surface of the unibody frame, and wherein the flexible backplane (200) is laminated directly to the rigid surface by the adhesive layer (110).

16. The method of Claim 15, comprising:
transfer-printing a thin film photovoltaic layer on a surface of a thermally conductive and electrically insulating interposer substrate (31) to define the respective solar cells (35); and
surface-mounting the interposer substrates (31) to the flexible backplane (200) to define the array of solar cells (35) prior to laminating the flexible backplane (200) to the rigid surface of the module enclosure (100).

17. The method of Claim 16, wherein laminating the flexible backplane (200) comprises:
depositing the adhesive layer (110) on a surface of the flexible backplane opposite the one or more solar cells (35) and/or on the rigid surface of the enclosure (100);
aligning the flexible backplane (200) with a reference indicator on the rigid surface; and
bonding the flexible backplane (200) to the rigid surface with the adhesive layer (110) using a vacuum lamination process, hot-roll lamination process, or substantially even pressure distribution.

18. The method of Claim 15 or any claim dependent on Claim 15, wherein the primary lens element (400) comprises an array of lenslets, and wherein attaching the primary lens element comprises:
providing a continuous sealing layer (102) along a perimeter of the unibody frame and/or the primary lens element (400);
aligning the primary lens element (400) with the solar cells (35) on the rigid surface such that the lenslets are positioned to concentrate light onto respective ones of the solar cells through the respective secondary lens element (50) thereon; and
contacting the primary lens element (400) with the perimeter of the unibody frame such that the sealing layer (102) provides a continuous seal along the perimeter.

19. The method of Claim 15 or any claim dependent on Claim 15, comprising:
pulling the rigid surface against a substantially planar reference surface; and then
attaching a thermally conductive rail structure (600) to the rigid surface opposite the flexible backplane (200) and outside of the enclosure (100), wherein the rail structure (600) increases a flatness and/or stiffness of the rigid surface.

20. The method of Claim 19, comprising:
attaching a junction box assembly (500) to the rigid surface opposite the flexible backplane (200) and outside of the enclosure (100), the junction box assembly (500) comprising electrically conductive structures (501) that extend through an opening (101) in the rigid surface to contact the interconnect network (34) of the flexible backplane (200) and provide electrical connections between the solar cells (35) and one or more external terminals.

21. The method of Claim 12 or Claim 13, wherein the module enclosure is a unibody module enclosure, the method further comprising:
attaching a thermally conductive rail structure (600) to the rigid surface of the module enclosure (100) opposite the flexible backplane (200), wherein the rail structure (600) increases a flatness and/or stiffness of the rigid surface; and
attaching a junction box assembly (500) to the rigid surface of the module enclosure (100) opposite the flexible backplane (200), the junction assembly (500) comprising electrically conductive structures (501) that extend through an opening (101) in the rigid surface to contact the interconnect network (34) of the flexible backplane (200) and provide electrical connections to external terminals.

22. The method of Claim 21 when dependent on claim 13, wherein the step of laminating the flexible backplane (200) comprises:
depositing the adhesive layer (110) on a surface of the flexible backplane (200) opposite the one or more solar cells (35) and/or on the rigid surface of the enclosure (100);
aligning the flexible backplane (200) with a reference indicator on the rigid surface; and
bonding the flexible backplane (200) to the rigid surface with the adhesive layer (110) using a vacuum lamination process, hot-roll lamination process, or substantially even pressure distribution.

## Patentansprüche

1. Konzentrator-Photovoltaikmodul, umfassend:
ein Modulgehäuse (100) mit einer starren unteren Oberfläche;
eine flexible Backplane (200) innerhalb des Gehäuses (100) und durch eine Klebeschicht (110) auf die starre untere Oberfläche laminiert, wobei die flexible Backplane (200) eine Anordnung von Interposer-Substraten (31) mit darauf transfergedruckten Solarzellen (35) und ein Verbindungsnetz (34) umfasst, das elektrische Verbindungen zu den Solarzellen (35) bereitstellt;
ein jeweiliges sphärisch geformtes Sekundärlinsenelement (50) auf jeweiligen Solarzellen (35) innerhalb des Gehäuses (100);
eine optisch transparente Verkapselungsschicht (41) auf einer Oberfläche des jeweiligen Sekundärlinsenelements (50), wobei die Verkapselungsschicht (41) das jeweilige Sekundärlinsenelement (50) überzieht, wobei die Verkapselungsschicht (41) eine optisch klare Silikonschicht ist, und wobei die Oberfläche des jeweiligen Sekundärlinsenelements einschließlich der Verkapselungsschicht darauf einen anderen Brechungsindex als die des Sekundärlinsenelements aufweist; und
ein Primärlinsenelement (400), das am Gehäuse (100) gegenüber der starren unteren Oberfläche angebracht und von dieser beabstandet ist, wobei das Primärlinsenelement (400) positioniert ist, um Licht auf die jeweiligen Solarzellen (35) durch das Sekundärlinsenelement (50) darauf zu konzentrieren.

2. Modul nach Anspruch 1, umfassend:
einen transparenten Klebstoff auf einer jeweiligen nach oben weisenden Oberfläche der Solarzellen (35) und Anbringen des jeweiligen Sekundärlinsenelements (50) darauf, wobei der transparente Klebstoff eine optisch klare Silikonschicht ist.

3. Modul nach Anspruch 2, wobei das jeweilige Sekundärlinsenelement (50) einen oder mehrere Defekte in seiner Oberfläche aufweist, und wobei die Verkapselungsschicht im Wesentlichen den einen oder die mehreren Defekte ausfüllt, um die Oberfläche des jeweiligen Sekundärlinsenelements (50) zu glätten.

4. Modul nach Anspruch 3, wobei die Solarzellen (35) eine jeweilige Abstandshalterstruktur (36) auf der jeweiligen nach oben weisenden Oberfläche davon einschließen, und wobei das Sekundärlinsenelement (50) davon durch die Abstandshalterstruktur (36) selbstzentriert ist.

5. Modul nach Anspruch 4, wobei das Modulgehäuse (100) einen Unibody-Rahmen mit einer Geometrie mit geschlossenem Boden umfasst, wobei die starre Oberfläche eine untere Oberfläche des Unibody-Rahmens bereitstellt, und wobei die flexible Backplane (200) durch die Klebeschicht (110) direkt auf die starre Oberfläche laminiert ist.

6. Modul nach Anspruch 5, umfassend:
eine thermisch leitfähige Schienenstruktur (600), die an der starren Oberfläche gegenüber der flexiblen Backplane (200) und außerhalb des Gehäuses (100) angebracht ist, wobei die Schienenstruktur (600) eine Ebenheit und/oder Steifigkeit der starren Oberfläche erhöht.

7. Modul nach Anspruch 6, umfassend:
eine Anschlussdosenanordnung (500), die an der starren Oberfläche gegenüber der flexiblen Backplane (200) und außerhalb des Gehäuses (100) angebracht ist, wobei die Anschlussdosenanordnung (500) elektrisch leitfähige Strukturen (501) umfasst, die sich durch eine Öffnung (101) in der starren Oberfläche erstrecken, um das Verbindungsnetz (34) der flexiblen Backplane (200) zu kontaktieren und elektrische Verbindungen zwischen den Solarzellen (35) und einem oder mehreren externen Anschlüssen bereitzustellen.

8. Modul nach Anspruch 5 oder einem von Anspruch 5 abhängigen Anspruch, wobei die Solarzellen (35) jeweils ein thermisch leitfähiges und elektrisch isolierendes Interposer-Substrat (31), das an der flexiblen Backplane (200) oberflächenmontiert ist, und eine Dünnfilm-Photovoltaikschicht, die auf das Interposer-Substrat transfergedruckt (31) wird, umfassen.

9. Modul nach Anspruch 8, wobei das Primärlinsenelement (400) eine Anordnung von kleinen Linsen umfasst, die am Unibody-Rahmen durch eine kontinuierliche Dichtung angebracht sind, die sich entlang eines Umfangs des Unibody-Rahmens erstreckt.

10. Modul nach Anspruch 9, wobei die flexible Backplane (200) eine Dicke von etwa 0,063 Zoll oder weniger aufweist, wobei die eine oder die mehreren Solarzellen (35) jeweilige Oberflächenbereiche von weniger als 1 Quadratmillimeter aufweisen, und wobei die kleinen Linsen des Primärlinsenelements (400) jeweils eine Linsen-zu-Zellen-Lichtkonzentration von etwa dem 1000 fachen oder mehr bereitstellen.

11. Modul nach einem der vorhergehenden Ansprüche, wobei das Verbindungsnetz (34) die Solarzellen (35) in parallelen Blöcken elektrisch verbindet, wobei eine jeweilige Sperrvorspannungs-Schutzdiode auf der flexiblen Backplane (200) mit jedem parallelen Block von Solarzellen (35) parallel verbunden ist.

12. Verfahren zum Herstellen eines Konzentrator-Photovoltaikmoduls, das Verfahren umfassend:
Laminieren einer flexiblen Backplane (200) an eine innere starre Oberfläche eines Modulgehäuses (100) unter Verwendung einer Klebeschicht (110), wobei die flexible Backplane (200) eine Anordnung von Interposer-Substraten (31) mit darauf transfergedruckten Solarzellen (35) und ein Verbindungsnetz (34) umfasst, das elektrische Verbindungen zu den Solarzellen (35) bereitstellt;
Bereitstellen eines jeweiligen sphärisch geformten Sekundärlinsenelements (50) auf jeweiligen Solarzellen (35) innerhalb des Gehäuses (100);
Aufbringen einer optisch transparenten Verkapselungsschicht (40, 41) auf dem Sekundärlinsenelement (50) der jeweiligen Solarzellen (35), wobei eine Oberfläche des Sekundärlinsenelements (50) einschließlich der Verkapselungsschicht (40, 41) darauf einen anderen Brechungsindex als die des Sekundärlinsenelements (50) aufweist, und wobei die optisch transparente Verkapselungsschicht eine optisch klare Silikonschicht ist;
und
Anbringen eines Primärlinsenelements (400) am Gehäuse (100) gegenüber der starren Oberfläche und von dieser beabstandet, wobei das Primärlinsenelement (400) positioniert ist, um Licht auf die jeweiligen Solarzellen (35) durch das Sekundärlinsenelement (50) darauf zu konzentrieren.

13. Verfahren nach Anspruch 12, wobei das Bereitstellen des Sekundärlinsenelements (50) auf den jeweiligen Solarzellen (35) umfasst:
Verteilen eines transparenten Klebstoffs (40, 41) auf die jeweiligen Solarzellen (35) gegenüber der Backplane (200), wobei der transparente Klebstoff eine optisch klare Silikonschicht ist; und
Bereitstellen des sphärisch geformten Sekundärlinsenelements (50) auf dem transparenten Klebstoff (40, 41) auf den jeweiligen Solarzellen (35), wobei das Sekundärlinsenelement (50) einen oder mehrere Defekte in seiner Oberfläche einschließt,
und wobei das Aufbringen der optisch transparenten Verkapselungsschicht (40, 41) umfasst:
Aufbringen der optisch transparenten Verkapselungsschicht (40, 41), um im Wesentlichen den einen oder die mehreren Defekte auszufüllen, um die Oberfläche des Sekundärlinsenelements (50) der jeweiligen Solarzellen (35) zu glätten.

14. Verfahren nach Anspruch 13, wobei die Solarzellen (35) eine jeweilige Abstandshalterstruktur (36) auf einer Oberfläche davon einschließen, und wobei das Sekundärlinsenelement (50) durch die Abstandshalterstruktur selbstzentriert ist.

15. Verfahren nach Anspruch 14, wobei das Modulgehäuse (100) einen Unibody-Rahmen mit einer Geometrie mit geschlossenem Boden umfasst, wobei die starre Oberfläche eine untere Oberfläche des Unibody-Rahmens definiert, und wobei die flexible Backplane (200) durch die Klebeschicht (110) direkt auf die starre Oberfläche laminiert ist.

16. Verfahren nach Anspruch 15, umfassend:
Transferdrucken einer Dünnfilm-Photovoltaikschicht auf eine Oberfläche eines thermisch leitfähigen und elektrisch isolierenden Interposer-Substrats (31), um die jeweiligen Solarzellen (35) zu definieren; und
Oberflächenmontieren der Interposer-Substrate (31) an der flexiblen Backplane (200), um die Anordnung von Solarzellen (35) vor dem Laminieren der flexiblen Backplane (200) an die starre Oberfläche des Modulgehäuses (100) zu definieren.

17. Verfahren nach Anspruch 16, wobei das Laminieren der flexiblen Backplane (200) umfasst:
Aufbringen der Klebeschicht (110) auf einer Oberfläche der flexiblen Backplane gegenüber der einen oder den mehreren Solarzellen (35) und/oder auf der starren Oberfläche des Gehäuses (100);
Ausrichten der flexiblen Backplane (200) mit einem Referenzindikator auf der starren Oberfläche; und
Bonden der flexiblen Backplane (200) mit der starren Oberfläche mit der Klebeschicht (110) unter Verwendung eines Vakuumlaminierungsprozesses, eines Heißwalzenlaminierungsprozesses oder einer im Wesentlichen gleichmäßigen Druckverteilung.

18. Verfahren nach Anspruch 15 oder einem von Anspruch 15 abhängigen Anspruch, wobei das Primärlinsenelement (400) eine Anordnung von kleinen Linsen umfasst, und wobei das Anbringen des Primärlinsenelements umfasst:
Bereitstellen einer kontinuierlichen Dichtungsschicht (102) entlang eines Umfangs des Unibody-Rahmens und/oder des Primärlinsenelements (400) ;
Ausrichten des Primärlinsenelements (400) mit den Solarzellen (35) auf der starren Oberfläche, so dass die kleinen Linsen positioniert sind, um Licht auf die jeweiligen Solarzellen durch das jeweilige Sekundärlinsenelement (50) darauf zu konzentrieren; und
Kontaktieren des Primärlinsenelements (400) mit dem Umfang des Unibody-Rahmens, so dass die Dichtungsschicht (102) eine kontinuierliche Dichtung entlang des Umfangs bereitstellt.

19. Verfahren nach Anspruch 15 oder einem von Anspruch 15 abhängigen Anspruch, umfassend:
Ziehen der starren Oberfläche gegen eine im Wesentlichen ebene Referenzoberfläche; und dann
Anbringen einer thermisch leitfähigen Schienenstruktur (600) an der starren Oberfläche gegenüber der flexiblen Backplane (200) und außerhalb des Gehäuses (100), wobei die Schienenstruktur (600) eine Ebenheit und/oder Steifigkeit der starren Oberfläche erhöht.

20. Verfahren nach Anspruch 19, umfassend:
Anbringen einer Anschlussdosenanordnung (500) an der starren Oberfläche gegenüber der flexiblen Backplane (200) und außerhalb des Gehäuses (100), wobei die Anschlussdosenanordnung (500) elektrisch leitfähige Strukturen (501) umfasst, die sich durch eine Öffnung (101) in der starren Oberfläche erstrecken, um das Verbindungsnetz (34) der flexiblen Backplane (200) zu kontaktieren und elektrische Verbindungen zwischen den Solarzellen (35) und einem oder mehreren externen Anschlüssen bereitzustellen.

21. Verfahren nach Anspruch 12 oder Anspruch 13, wobei das Modulgehäuse ein Unibody-Modulgehäuse ist, das Verfahren ferner umfassend:
Anbringen einer thermisch leitfähigen Schienenstruktur (600) an der starren Oberfläche des Modulgehäuses (100) gegenüber der flexiblen Backplane (200), wobei die Schienenstruktur (600) eine Ebenheit und/oder Steifigkeit der starren Oberfläche erhöht; und
Anbringen einer Anschlussdosenanordnung (500) an der starren Oberfläche des Modulgehäuses (100) gegenüber der flexiblen Backplane (200), wobei die Anschlussanordnung (500) elektrisch leitfähige Strukturen (501) umfasst, die sich durch eine Öffnung (101) in der starren Oberfläche erstrecken, um das Verbindungsnetz (34) der flexiblen Backplane (200) zu kontaktieren und externen Anschlüssen elektrische Verbindungen bereitzustellen.

22. Verfahren nach Anspruch 21, wenn abhängig von Anspruch 13, wobei der Schritt des Laminierens der flexiblen Backplane (200) umfasst:
Aufbringen der Klebeschicht (110) auf einer Oberfläche der flexiblen Backplane (200) gegenüber der einen oder den mehreren Solarzellen (35) und/oder auf der starren Oberfläche des Gehäuses (100);
Ausrichten der flexiblen Backplane (200) mit einem Referenzindikator auf der starren Oberfläche; und
Bonden der flexiblen Backplane (200) mit der starren Oberfläche mit der Klebeschicht (110) unter Verwendung eines Vakuumlaminierungsprozesses, eines Heißwalzenlaminierungsprozesses oder einer im Wesentlichen gleichmäßigen Druckverteilung.

## Revendications

1. Module photovoltaïque de type concentrateur, comprenant :
une enceinte de module (100) ayant une surface inférieure rigide ;
un fond de panier flexible (200) à l'intérieur de l'enceinte (100) et stratifié sur la surface inférieure rigide au moyen d'une couche adhésive (110), le fond de panier flexible (200) comprenant un ensemble de substrats d'interposition (31) comprenant des cellules solaires imprimées par transfert (35) sur ces derniers et un réseau d'interconnexion (34) qui fournit des connexions électriques aux cellules solaires (35) ;
un élément de lentille de forme sphérique secondaire respectif (50) sur des cellules solaires respectives des cellules solaires (35) à l'intérieur de l'enceinte (100) ;
une couche d'agent d'encapsulation optiquement transparente (41) sur une surface de l'élément de lentille secondaire respectif (50), dans lequel la couche d'agent d'encapsulation (41) recouvre l'élément de lentille secondaire respectif (50), dans lequel la couche d'agent d'encapsulation (41) est une couche de silicone optiquement claire et dans lequel la surface de l'élément de lentille secondaire respectif comprenant la couche d'agent d'encapsulation sur ce dernier présente un indice de réfraction différent de celui de l'élément de lentille secondaire ; et
un élément de lentille primaire (400) fixé à l'enceinte (100) à l'opposé, et espacé, de la surface inférieure rigide, dans lequel l'élément de lentille primaire (400) est positionné de sorte à concentrer de la lumière sur les cellules solaires respectives des cellules solaires (35) au moyen de l'élément de lentille secondaire (50) sur ces dernières.

2. Module selon la revendication 1, comprenant :
un adhésif transparent sur une surface respective orientée vers le haut des cellules solaires (35) et fixant l'élément de lentille secondaire respectif (50) sur cette dernière, dans lequel ledit adhésif transparent est une couche de silicone optiquement claire.

3. Module selon la revendication 2, dans lequel l'élément de lentille secondaire respectif (50) comprend un ou plusieurs défauts dans la surface de ce dernier et dans lequel la couche d'agent d'encapsulation remplit sensiblement le ou les défauts pour lisser la surface de l'élément de lentille secondaire respectif (50).

4. Module selon la revendication 3, dans lequel les cellules solaires (35) comprennent une structure d'entretoise respective (36) sur la surface respective orientée vers le haut de ces dernières et dans lequel l'élément de lentille secondaire (50) de ces dernières est centré automatiquement par la structure d'entretoise (36) .

5. Module selon la revendication 4, dans lequel l'enceinte de module (100) comprend un cadre monocorps ayant une géométrie de fond fermé, dans lequel la surface rigide fournit une surface inférieure du cadre monocorps et dans lequel le fond de panier flexible (200) est stratifié directement sur la surface rigide au moyen de la couche adhésive (110).

6. Module selon la revendication 5, comprenant :
une structure de rail thermoconductrice (600) fixée à la surface rigide à l'opposé du fond de panier flexible (200) et à l'extérieur de l'enceinte (100), dans lequel la structure de rail (600) augmente la planéité et/ou la rigidité de la surface rigide.

7. Module selon la revendication 6, comprenant :
un ensemble boîte de raccordement (500) fixé à la surface rigide à l'opposé du fond de panier flexible (200) et à l'extérieur de l'enceinte (100), l'ensemble boîte de raccordement (500) comprenant des structures électroconductrices (501) qui s'étendent à travers une ouverture (101) dans la surface rigide pour venir en contact avec le réseau d'interconnexion (34) du fond de panier flexible (200) et fournissent des connexions électriques entre les cellules solaires (35) et une ou plusieurs bornes externes.

8. Module selon la revendication 5 ou selon n'importe quelle revendication dépendante de la revendication 5, dans lequel les cellules solaires (35) comprennent respectivement un substrat d'interposition thermoconducteur et électro-isolant (31) qui est monté en surface sur le fond de panier flexible (200), et une couche photovoltaïque à film mince qui est imprimée par transfert sur le substrat d'interposition (31).

9. Module selon la revendication 8, dans lequel l'élément de lentille primaire (400) comprend un réseau de microlentilles fixées au cadre monocorps au moyen d'un joint d'étanchéité continu s'étendant le long d'un périmètre du cadre monocorps.

10. Module selon la revendication 9, dans lequel le fond de panier flexible (200) présente une épaisseur égale ou inférieure à environ 0,063 pouce, dans lequel la ou les cellules solaires (35) présentent des aires respectives inférieures à 1 millimètre carré et dans lequel les microlentilles de l'élément de lentille primaire (400) assurent respectivement une concentration de lumière des lentilles aux cellules égale ou supérieure à 1 000 fois.

11. Module selon l'une quelconque des revendications précédentes, dans lequel le réseau d'interconnexion (34) raccorde électriquement les cellules solaires (35) dans des blocs parallèles, dans lequel une diode de protection en polarisation inverse respective sur le fond de panier flexible (200) est raccordée en parallèle à chaque bloc parallèle de cellules solaires (35).

12. Procédé de fabrication d'un module photovoltaïque de type concentrateur, le procédé consistant :
à stratifier un fond de panier flexible (200) sur une surface rigide interne d'une enceinte de module (100) au moyen d'une couche adhésive (110), le fond de panier flexible (200) comprenant un ensemble de substrats d'interposition (31) comprenant des cellules solaires imprimées par transfert (35) sur ces derniers et un réseau d'interconnexion (34) qui fournit des connexions électriques aux cellules solaires (35) ;
à fournir un élément de lentille de forme sphérique secondaire respectif (50) sur des cellules solaires respectives des cellules solaires (35) à l'intérieur de l'enceinte (100) ;
à déposer une couche d'encapsulation optiquement transparente (40, 41) sur l'élément de lentille secondaire (50) des cellules solaires respectives des cellules solaires (35), dans lequel une surface de l'élément de lentille secondaire (50) comprenant la couche d'encapsulation (40, 41) sur ce dernier présente un indice de réfraction différent de celui de l'élément de lentille secondaire (50) et dans lequel ladite couche d'encapsulation optiquement transparente est une couche de silicone optiquement claire ;
et
à fixer un élément de lentille primaire (400) à l'enceinte (100) à l'opposé, et espacé, de la surface rigide, dans lequel l'élément de lentille primaire (400) est positionné de sorte à concentrer de la lumière sur les cellules solaires respectives des cellules solaires (35) au moyen de l'élément de lentille secondaire (50) sur ces dernières.

13. Procédé selon la revendication 12, dans lequel la fourniture de l'élément de lentille secondaire (50) sur les cellules respectives des cellules respectives (35) consiste :
à distribuer un adhésif transparent (40, 41) sur les cellules solaires respectives des cellules solaires (35) à l'opposé du fond de panier (200), dans lequel ledit adhésif transparent est une couche de silicone optiquement claire ; et
à disposer l'élément de lentille secondaire de forme sphérique (50) sur l'adhésif transparent (40, 41) sur les cellules solaires respectives des cellules solaires (35), dans lequel l'élément de lentille secondaire (50) comprend un ou plusieurs défauts dans la surface de ce dernier,
et dans lequel le dépôt de la couche d'encapsulation optiquement transparente (40, 41) consiste :
à déposer la couche d'encapsulation optiquement transparente (40, 41) de sorte à remplir sensiblement le ou les défauts pour lisser la surface de l'élément de lentille secondaire respectif (50) des cellules solaires respectives des cellules solaires (35).

14. Procédé selon la revendication 13, dans lequel les cellules solaires (35) comprennent une structure d'entretoise respective (36) sur une surface de ces dernières et dans lequel l'élément de lentille secondaire (50) est centré automatiquement par la structure d'entretoise.

15. Procédé selon la revendication 14, dans lequel l'enceinte de module (100) comprend un cadre monocorps ayant une géométrie de fond fermé, dans lequel la surface rigide définit une surface inférieure du cadre monocorps et dans lequel le fond de panier flexible (200) est stratifié directement sur la surface rigide au moyen de la couche adhésive (110).

16. Procédé selon la revendication 15, consistant :
à imprimer par transfert une couche photovoltaïque à film mince sur une surface d'un substrat d'interposition thermoconducteur et électro-isolant (31) pour définir les cellules solaires respectives (35) ; et
à monter en surface les substrats d'interposition (31) sur le fond de panier flexible (200) pour définir le réseau de cellules solaires (35) avant de stratifier le fond de panier flexible (200) sur la surface rigide de l'enceinte de module (100).

17. Procédé selon la revendication 16, dans lequel la stratification du fond de panier flexible (200) consiste :
à déposer la couche adhésive (110) sur une surface du fond de panier flexible à l'opposé de la ou des cellules solaires (35) et/ou sur la surface rigide de l'enceinte (100) ;
à aligner le fond de panier flexible (200) avec un indicateur de référence sur la surface rigide ; et
à relier le fond de panier flexible (200) à la surface rigide avec la couche adhésive (110) à l'aide d'un processus de stratification sous vide, d'un processus de stratification à chaud ou d'une répartition de pression sensiblement égale.

18. Procédé selon la revendication 15 ou selon n'importe quelle revendication dépendante de la revendication 15, dans lequel l'élément de lentille primaire (400) comprend un réseau de microlentilles et dans lequel la fixation de l'élément de lentille primaire consiste :
à fournir une couche d'étanchéité continue (102) le long d'un périmètre du cadre monocorps et/ou de l'élément de lentille primaire (400) ;
à aligner l'élément de lentille primaire (400) avec les cellules solaires (35) sur la surface rigide de telle sorte que les microlentilles soient est positionnées de sorte à concentrer de la lumière sur des cellules solaires respectives des cellules solaires au moyen de l'élément de lentille secondaire respectif (50) sur ces dernières ; et
à mettre en contact l'élément de lentille primaire (400) avec le périmètre du cadre monocorps de telle sorte que la couche d'étanchéité (102) fournisse un joint d'étanchéité continu le long du périmètre.

19. Procédé selon la revendication 15 ou selon n'importe quelle revendication dépendante de la revendication 15, consistant :
à tirer la surface rigide contre une surface de référence sensiblement plane ; et, ensuite,
à fixer une structure de rail thermoconductrice (600) à la surface rigide à l'opposé du fond de panier flexible (200) et à l'extérieur de l'enceinte (100), dans lequel la structure de rail (600) augmente la planéité et/ou la rigidité de la surface rigide.

20. Procédé selon la revendication 19, consistant :
à fixer un ensemble boîte de raccordement (500) à la surface rigide à l'opposé du fond de panier flexible (200) et à l'extérieur de l'enceinte (100), l'ensemble boîte de raccordement (500) comprenant des structures électroconductrices (501) qui s'étendent à travers une ouverture (101) dans la surface rigide pour venir en contact avec le réseau d'interconnexion (34) du fond de panier flexible (200) et fournissent des connexions électriques entre les cellules solaires (35) et une ou plusieurs bornes externes.

21. Procédé selon la revendication 12 ou la revendication 13, dans lequel l'enceinte de module est une enceinte de module monocorps, le procédé consistant :
à fixer une structure de rail thermoconductrice (600) à la surface rigide de l'enceinte de module (100) à l'opposé du fond de panier flexible (200), dans lequel la structure de rail (600) augmente la planéité et/ou la rigidité de la surface rigide ; et
à fixer un ensemble boîte de raccordement (500) à la surface rigide de l'enceinte de module (100) à l'opposé du fond de panier flexible (200), l'ensemble de raccordement (500) comprenant des structures électroconductrices (501) qui s'étendent à travers une ouverture (101) dans la surface rigide pour venir en contact avec le réseau d'interconnexion (34) du fond de panier flexible (200) et fournissent des connexions électriques à des bornes externes.

22. Procédé selon la revendication 21 lorsqu'elle est dépendante de la revendication 13, dans lequel l'étape de stratification du fond de panier flexible (200) consiste :
à déposer la couche adhésive (110) sur une surface du fond de panier flexible (200) à l'opposé de la ou des cellules solaires (35) et/ou sur la surface rigide de l'enceinte (100) ;
à aligner le fond de panier flexible (200) avec un indicateur de référence sur la surface rigide ; et
à relier le fond de panier flexible (200) à la surface rigide avec la couche adhésive (110) à l'aide d'un processus de stratification sous vide, d'un processus de stratification à chaud ou d'une répartition de pression sensiblement égale.
